# EUROPEAN PATENT SPECIFICATION

(11) **EP 3 138 732 B1**
(45) Date of publication and mention of the grant of the patent: **16.06.2021**
(21) Application number: 16185484.9
(22) Date of filing: 24.08.2016
(51) Int. Cl.: B60Q 1/08, H01S 5/06, F21S 41/16, B60Q 1/14, B60Q 11/00, F21S 41/176, F21S 45/70, B60Q 1/00, B60Q 1/04, H01S 5/068

(54) **LIGHTING SYSTEM AND VEHICLE HEADLIGHT SYSTEM USING THE SAME**
BELEUCHTUNGSSYSTEM UND FAHRZEUGSCHEINWERFERSYSTEM DAMIT
SYSTÈME D'ÉCLAIRAGE ET SYSTÈME DE PHARES DE VÉHICULE UTILISANT CELUI-CI

(30) Priority: 24.08.2015 JP 2015165165
(43) Date of publication of application: 08.03.2017
(73) Proprietor: Stanley Electric Co., Ltd., Meguro-ku Tokyo 153-8636 (JP)
(72) Inventor: ADACHI, Koji, Tokyo 153-8636 (JP)
(74) Representative: Carstens, Dirk Wilhelm

(56) References cited:
- WO-A1-2012/124607
- DE-A1-102012 220 481
- US-A1- 2009 257 240
- US-A1- 2014 334 167

## Description

### BACKGROUND

The present invention relates to lighting systems including a laser light-emitting device and a wavelength converting material as a light source, and relates to vehicle headlight systems using the lighting system, and more particularly to the lighting systems, which can prevent the light source from leaking a laser beam in an outward direction of the lighting systems even when the light source emitting the laser beam receives a big shock, and the vehicle headlight systems using such a lighting system, which can operate in an eye-safe function when the headlight receives big shocks and also can turn off the laser light-emitting device by anticipating a degradation of the light source.

Light sources emitting a laser beam may emit light having a high light-intensity, and therefore have been used for various lighting systems such as a vehicle headlight. Such light sources emitting the laser beam may emit light having various color tones including a substantially white color light by combining a wavelength converting material with the laser beam. However, when the light source including the wavelength converting material does not wavelength-convert the laser beam but emits a direct laser beam because the wavelength converting material moves from a light-emitting direction of the laser beam due to shocks, the direct laser beam may be dangerous to human eyes.

Therefore, laser light sources including an eye-safe function have been developed. For example, a conventional light source including the eye-safe function is disclosed in JP 2014-165450A. FIG. 14 is a schematic side cross-sectional view showing the conventional light source including a semiconductor laser chip and a wavelength converting material, which is disclosed in JP 2014-165450A.

The conventional light source 100 includes: a semiconductor laser chip 105 electrically connected between a first chip electrode 102 and a second chip electrode 103; a wavelength converting plate 111 having a light-reflecting electrode 111b and an opening 111C of the light-reflecting electrode 111b, which is located in a middle portion of the reflecting electrode 111b so as to expose the wavelength converting plate 111 from the light-reflecting electrode 111b, and thereby the wavelength converting plate 111 receiving a laser beam emitted from the semiconductor laser chip 105 via the opening 111C of the light-reflecting electrode 111b and wavelength-converting the laser beam; a base board 110 including a first conductive pattern 110b and a second conductive pattern 110C, and each of the first conductive pattern 110b and the second conductive pattern 110C isolating with respect to each other, and electrically connecting to the light-reflecting electrode 111b via at least one bump 112; a first external electrode 113 electrically connected to the first conductive pattern 110b and the first chip electrode 102; and a second external electrode 114 electrically connected to the second conductive pattern 110C and the second chip electrode 103 via a power supply 120.

According to the conventional light source 100, when a switch 121 for the power supply 120 is connected between the first chip electrode 102 and the first external electrode 113, the laser chip 105 may emit the laser beam by turning on the switch 121, and may emit a mixture light having various color tones which mixes a wavelength-converted light by the wavelength converting plate 111 using a part of the laser beam as an exciting light with a direct laser light from the laser beam emitted from the laser chip 105. In this case, when the wavelength converting plate 111 is removed by shocks and the like, the laser chip 105 may turn off because the power supply 120 may not apply power between the first chip electrode 102 and the second chip electrode 103 even when the switch 121 turns on.

As described above, the conventional light source 100 may enable the laser chip 105 to turn off so as not to emit the laser beam with confidence when the wavelength converting plate 111 is removed by shocks and the like. However, the laser chip 105 should turn off by anticipating the break of the light source 100 especially when the conventional light source 100 is used as a light source for a vehicle headlight, etc. For example, when a subject vehicle incorporating the light source 100 may move, drivers may be difficult to safely drive the subject vehicle to a garage and the like, because the light source 100 cannot turn on.

Hence, a conventional headlight system including the eye-safe function is disclosed in JP 2015-506301 A. FIG. 15 is a schematic diagram showing the conventional headlight system including the eye-safe function, which is disclosed in JP 2015-506301 A. The conventional headlight system 200 includes: a headlight unit 201 including a headlight power supply 206, a laser light source 202, a wavelength converting material 203 and an optical device 204; a monitor unit 214 including a sensor evaluating circuit 211 and an air-bag controller 212; and a headlight controller 210 controlling the headlight unit 201 via a breaker 207 connecting to a vehicle battery 205 in accordance with signals output from monitor unit 214.

In this case, when the air-bag controller 212 detects a maximum acceleration rate or more, the air-bag controller 212 outputs an acceleration control signal 212S to the headlight controller 210, and the headlight controller 210 may turn off the laser light source 202 by cutting off the breaker 207. However, although the air-bag controller 212 may detect a large acceleration rate caused by an extremely big shock such that protects drivers from the big shock, the air-bag controller 212 may not necessarily detect a general acceleration rate caused by a big shock such that breaks the headlight. Accordingly, because only the air-bag controller 212 may not detect an acceleration rate caused by such the big shock, JP 2015-506301 A discloses that the air-bag controller 212 needs at least one signal output from a passive safety system to revise the acceleration rate.

In addition, the air-bag controller 212 may also cause a time lag to turn off the laser light source 202 because it is located adjacent a car interior, which is away from a headlight of the subject vehicle in general. Therefore, the laser lighting unit 201 includes a headlight cover sensor 201S, a position sensor 202S for the laser light source 202, etc. When the headlight cover breaks, the headlight cover sensor 201S outputs a cover-breaking signal to the sensor evaluating circuit 211, and the headlight controller 210 may turn off the laser light source 202 by cutting off the breaker 207 in accordance with an evaluating signal 211S output from the sensor evaluating circuit 211.

Similarly, when a misalignment of the laser light source 202 occurred, the position sensor 202S outputs a misalignment signal to the sensor evaluating circuit 211, and the headlight controller 210 may turn off the laser light source 202 by cutting off the breaker 207 in accordance with the evaluating signal 211S output from the sensor evaluating circuit 211. However, the conventional headlight system 200 may be subject to a complex structure due to many sensors described above. Additionally, the conventional headlight system 200 may not turn off the laser light source 202 by anticipating a degradation of the laser light source 202 in common with the above-described conventional light source 100.

WO 2012/12607 A1 discloses an illumination device comprising a headlamp unit that has a laser light source; a laser drive circuit that drives the laser light source; and an acceleration sensor that detects the acceleration of the headlamp unit. When the laser drive circuit is driving the laser light source and the detection value from the acceleration sensor exceeds a first threshold value, the laser drive circuit pulse drives the laser light source for a fixed period of time.

US 2009/257240 A1 discloses a vehicle lamp including a projector headlight using an LED light source for a low beam, the vehicle lamp including a shade, an LED light source, an ellipsoidal reflector and a projector lens. Both a focus of the projector lens and a top edge of the shade are located near a second focus of the reflector. The LED light source is located near a first focus located below the second focus of the reflector. Therefore, light emitted from the LED light source can be gathered near the focus of the projector lens via the reflector and can be projected via the projector lens with high light use-efficiency. The projector lens includes light dispersing portions or structures on an upside and downside thereof for reducing chromatic aberration.

The present invention has been devised to consider the above and other problems, characteristics and features. Therefore, exemplary embodiments of the invention can include vehicle headlight systems using a lighting system, which can turn off a laser light-emitting device by anticipating a degradation of a laser light source, and also can inform drivers of a subject vehicle about the degradation of the laser light source. Additionally, the lighting system, which can be used for the vehicle headlight systems, can emit light having various color tones including a substantially white color light, and therefore can also be used as a light source for various lighting units such as general lighting, a stage lighting, lighting for show windows, etc.

### SUMMARY OF THE INVENTION

The present invention been devised in view of the above and other characteristics, desires, and problems in the conventional art. An aspect of the invention can provide lighting systems including an eye-safe function, which can emit light having various color tones including a substantially white color light, and which can be used as a light source for various lighting units such as vehicle lamps, general lighting, a stage lighting, lighting for show windows, etc. Another aspect of the invention can provide vehicle headlight systems using the lighting system, which can turn off a laser light-emitting device of a laser light source by anticipating a degradation of the laser light source.

According to an aspect of the invention, a lighting system is provided as set forth in claim 1.

According to the aspect of the invention, the exemplary lighting system can emit various color lights including white color light, which mixes a wavelength-converted light by the wavelength converting material using a part of the laser beam emitted from the laser light-emitting device as an exciting light with another of the direct laser beam. Additionally, the controller can examine the connecting state between the wavelength converting material and the mounting board, and also can control to turn off the laser light-emitting device when the threshold is less than the value of the acceleration signal, which is caused by shocks. Thus, the invention can provide lighting systems including an eye-safe function, which can emit light having various color tones including a substantially white color light, and which can be used as a light source for various lighting units such as vehicle lamps, general lighting, a stage lighting, lighting for show windows, etc.

According to another aspect of the invention, a vehicle headlight system is provided as set forth in claim 3. The vehicle headlight system can turn off the laser light-emitting device by anticipating a degradation of the laser light source.

Preferred embodiments of the present invention may be gathered from the dependent claims.

### BRIEF DESCRIPTION OF THE DRAWINGS

These and other characteristics and features of the invention will become clear from the following description with reference to the accompanying drawings, wherein:
FIG. 1 is a schematic side cross-sectional view showing an exemplary embodiment of a vehicle headlight system using a lighting system made in accordance with principles of the invention;
FIG. 2 is a schematic side cross-sectional view depicting an exemplary light source emitting a laser beam included in the vehicle headlight system shown in FIG. 1;
FIG. 3 is a circuit block diagram showing a first exemplary embodiment of the vehicle headlight system shown in FIG. 1;
FIG. 4 is a first flow chart to explain an exemplary operation of the first embodiment of the vehicle headlight system shown in FIG. 3;
FIG. 5 is a second flow chart to explain an exemplary variation operation of the first embodiment of the vehicle headlight system when a lighting unit includes a communication line as shown in FIG. 3;
FIG. 6 is a circuit block diagram showing a second exemplary embodiment of the vehicle headlight system shown in FIG. 3, wherein the second embodiment may also be used as the lighting system of the invention;
FIG. 7 is a schematic side cross-sectional view depicting an exemplary wavelength converting portion of the light source included in the second embodiment of the vehicle headlight system shown in FIG. 1;
FIG. 8 is a schematic enlarged top view depicting the wavelength converting portion of the light source included in the second embodiment of the vehicle headlight system shown in FIG. 7;
FIG. 9 is a schematic side view depicting the light source including the wavelength converting portion in the second embodiment of the vehicle headlight system shown in FIG. 7, and shows an extending state of a flexible circuit board from the wavelength converting portion in an outward direction of the light source;
FIG. 10a is an equivalence circuit to examine a connecting state between a wavelength converting material and a mounting board using a controller, and FIG. 10b is a schematic side cross-sectional view showing an exemplary equivalent circuit model to examine the connecting state between the wavelength converting material and the mounting board of the wavelength converting portion;
FIG. 11 is a table showing an exemplary method for revising a threshold in accordance with the connecting state shown in FIG. 10a;
FIG. 12 is a second flow chart to explain an exemplary method for operating the second embodiment of the vehicle headlight system using the table shown FIG. 11;
FIG. 13 is a circuit block diagram showing a third exemplary embodiment of the vehicle headlight system shown in FIG. 1;

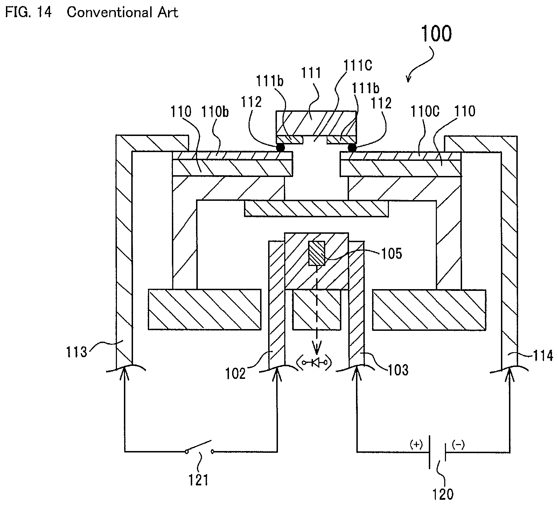

FIG. 14 is a schematic side cross-sectional view showing a conventional light source including a semiconductor laser chip and a wavelength converting material and also including an eye-safe function; and

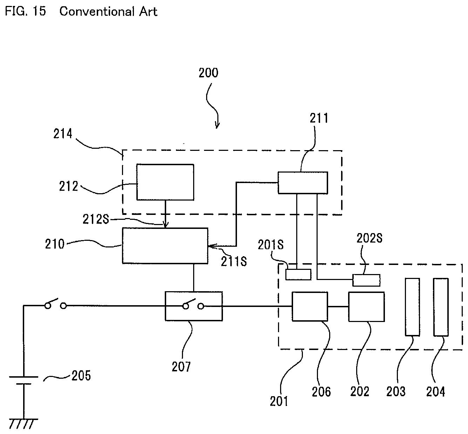

FIG. 15 is a schematic diagram showing a conventional headlight system including an eye-safe function.

### DESCRIPTION OF THE PREFERRED EMBODIMENTS

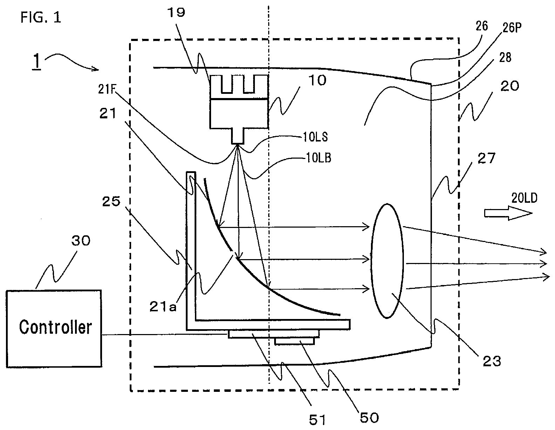

The invention will now be described in detail with reference to FIG. 1 to FIG. 13. Exemplary embodiments of a vehicle headlight system using a lighting system will now be described with reference to FIG. 1, which is a schematic side cross-sectional view showing an exemplary embodiment of the vehicle headlight system using the lighting system made in accordance with principles of the presently invention, in order to facilitate understandings of a basic idea of this invention. The vehicle lighting system 1 includes a lighting unit 20 having a lamp room 28 including a light source 10 and an acceleration sensor 50, which is located adjacent the light source 10 having a light-emitting surface 10LS, and a controller 30 to control the lighting unit 20.

The lighting unit 20 having a light-emitting direction 20LD can also include: a reflector 21 having a reflector opening 21a reflecting a laser beam 10LB emitted from the light source 10, formed in a substantially paraboloidal shape having a focus 21F so as to reflect the laser beam 10LB as a substantially parallel laser beam when the light-emitting surface 10LS of the light source 10 is located substantially at the focus 21F of the reflector 21, and the reflector opening 21a leaking a part of the laser beam 10LB from the reflector 21 when an amount of the laser beam 10LB needs to be limited; a projector lens 23 forming a desirable light distribution using said laser beam reflected by the reflector 21; a shading plate 25 located in a rearward direction of the reflector 21, located in an opposite direction of the projector lens 23 with respect to the reflector 21, and shading said leaked laser beam of the laser beam 10LB from the reflector 21; a heat sink 19 attached to the light source 10 to radiate a heat generated from the light source 10; a casing 26 having an opening 26P; an outer lens 27 made from a transparent material such as an epoxy resin, attached to the casing 26, covering the opening 26P of the casing 26, and thereby forming the lamp room 28, which is spaced between the outer lens 27 and the casing 26; and a circuit board 51 attached to the shading plate 25, mounting the acceleration sensor 51, and located in the lamp room 28 along with the light source 10, the reflector 21, the projector lens 23, etc.

The acceleration sensor 50 can detect an acceleration rate, which is received by the lighting unit 20. As the acceleration sensor 50, a piezoelectric acceleration sensor, a piezoresistive acceleration sensor, a capacitance acceleration sensor and the like can be used, and a single-axis sensor, a biaxial sensor and a triaxial sensor can be used as the number of axes of the acceleration sensor 50. Additionally, an acceleration sensor incorporating a resistor therein, which enables to conduct a digital-communication between the acceleration sensor 50 and the controller 30, can be used as the acceleration sensor 50.

When the acceleration sensor incorporating the resistor is used as the acceleration sensor 50, the controller 30 can watch an acceleration rate detected by the acceleration sensor 50 by transmitting the acceleration rate from the acceleration sensor 50 to the controller 30 using the resistor of the acceleration sensor in response to a request signal output from the controller 30. The acceleration sensor 50 can be attached to the shading plate 25 via the circuit board 51 at a position where the acceleration sensor 50 does not block the laser beam 10LB emitted from the light source 10 and the reflective laser beam reflected on the reflector 21 as shown FIG. 1.

In addition, the acceleration sensor 50 can be located in a frontward direction of the light source 10, which corresponds to a chain line shown in FIG. 1, in the lamp room 28 of the lighting unit 20, and can located between the light source 10 and projector lens 23. Thereby, when the lighting unit 20 received a shock from a light-emitting direction thereof, the acceleration sensor 50 can detect the acceleration rate of the shock at a high accuracy substantially without a time lag, and also can output the acceleration rate to the controller 30. The controller 30 can also control the light source 10, and cannot be necessarily located on the circuit board 51 in consideration of receiving the shock as described above.

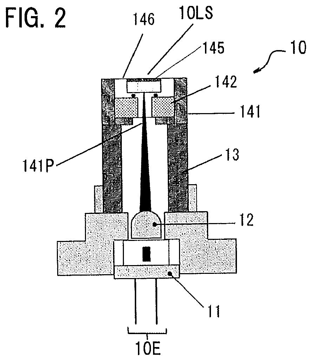

FIG. 2 is a schematic cross-sectional view depicting an exemplary light source emitting a laser beam of the lighting unit 20 included in the vehicle headlight system shown in FIG. 1. The light source 10 having the light-emitting surface 10LS can include: a laser light-emitting device 11 emitting a laser beam; an optical lens 12 located adjacent the laser light-emitting device 11, and focusing the laser beam toward the light-emitting surface 10LS; a first tubular holder 13 attaching the laser light-emitting device 11 and the optical lens 12; a wavelength converting material 145 configured to emit the laser beam 10LB having a desirable color tone from the light-emitting surface 10LS by wavelength-converting the laser beam; a wavelength converting holder 142 attaching the wavelength converting material 145; a reflective material 146 attaching the wavelength converting material 145 along with the wavelength converting holder 142, and configured to efficiently emit the laser beam 10LB from the light-emitting surface 10LS; and a second tubular holder 141 having a holder opening 141P attaching the wavelength converting material 145 via the wavelength converting holder 142 and the reflective material 146, and attached to the first tubular holder 13.

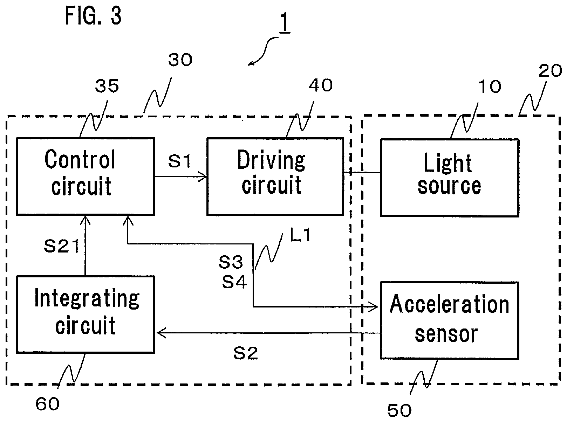

Accordingly, when a supply voltage is applied between electrodes 10E of the laser light-emitting device 11 of the light source 10, the above-described laser beam 10LB having the desirable color tone including a substantially white color light can be emitted from the light-emitting surface 10LS of the light source 10 toward the reflector 21 as described in FIG. 1. Exemplary basic operations of the vehicle headlight system 1 will now be described with reference to FIG. 3, which is a circuit block diagram showing a first exemplary embodiment of the vehicle headlight system shown in FIG. 1.

The vehicle headlight system 1 can include: a control circuit 35 of the controller 30 outputting a control signal S1 to control whether the light source 10 emits the laser beam 10LB or not; a driving circuit 40 included in the controller 30, receiving the control signal S1 from the control circuit 35, and driving the light source 10 of the lighting unit 20 in accordance with the control signal S1; the acceleration sensor 50 of the lighting unit 20 outputting an acceleration signal S2; an integrating circuit 60 such as a filter circuit included in the controller 30, removing noises included in the acceleration signal S2, and output said normal acceleration signal S21 substantially not including the noises to the control circuit 35.

The above-described controller 30 can include a computer system including a central processing unit (CPU), a read-only memory (ROM), a random access memory (RAM) and the like, and can be operated to control the driving circuit 40 in accordance with the control signal S1 output from the control circuit 35 and to remove the noises from the acceleration signal S2 output from the acceleration sensor 50 by using a software of signal-denoising while running a program from the ROM. Accordingly, the controller 30 can also output the control signal S1 to the driving circuit 40 included therein, and also can receive, as an input, the acceleration signal S2 directly from the acceleration sensor 50 without the integrating circuit 60 as appropriate.

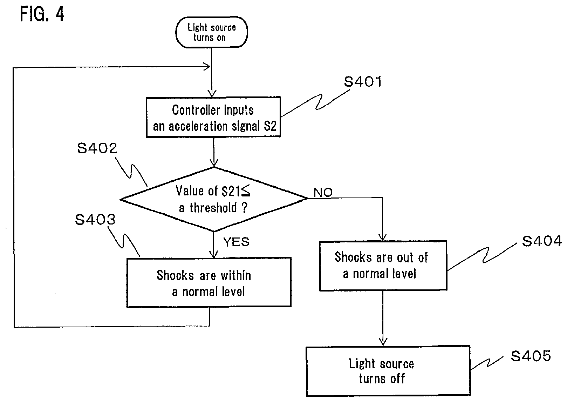

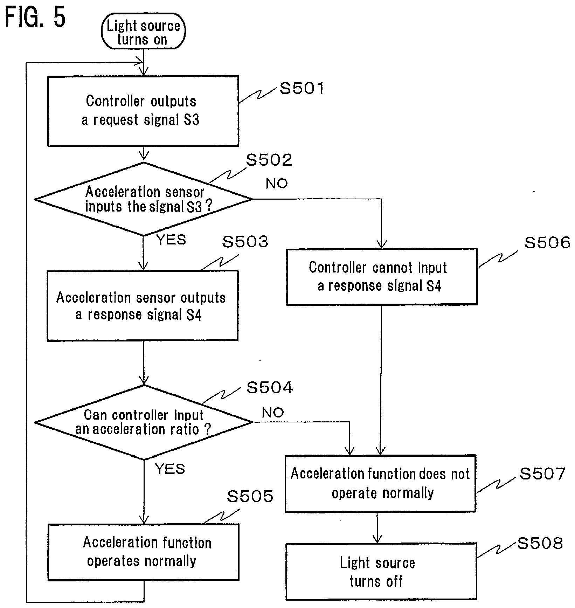

When the acceleration sensor 50 includes a communication function, the control circuit 35 of the controller 30 can output the request signal S3 to the acceleration sensor 50, and also can receive, as an input, a response signal S4 including the acceleration rate output from the acceleration sensor 50 in response of the request signal S3. In this case, when the acceleration sensor 50 and/or a communication line L1 between the acceleration sensor 50 and the control circuit 35 malfunctions, the control circuit 35 may not receive the normal response signal S4. More details of the operations will now be described with reference to flow charts shown in FIG. 4 and FIG. 5.

While the light source 10 turns on, the control circuit 35 of the controller 30 can input the normal acceleration signal S21 not including the noises via the integrating circuit 60 inputting the acceleration signal 2 as described above (Step S401). The control circuit 35 can compare the normal acceleration signal S21 with a threshold, which is predetermined (Step S402). When a value of the normal acceleration signal S21 is the threshold or less, the control circuit 35 of the controller 30 can determine that shocks received by the lighting unit 20 are with a normal level (Step S403).

Accordingly, the controller 30 can control to emit the laser beam 10LB from the light source 10. However, when the value of the normal acceleration signal S21 is more than the threshold, the control circuit 35 of the controller 30 can determine that the shocks received by the lighting unit 20 are out of the normal level, for example, the lighting unit 20 does not operate normally (Step S404). In this case, the controller 30 can control to turn off the light source 10 (Step S405) as shown in FIG. 4.

Exemplary operations of a case where the lighting system includes the communication line L1 will now be described with reference to FIG. 5. While the light source 10 turns on, the control circuit 35 of the controller 30 can output the request signal S3 to the acceleration sensor 50 at a predetermined communication rate (Step S501). When the acceleration sensor 50 and/or the communication line L1 between the acceleration sensor 50 and the controller 30 does not operate normally (Step S502: NO), the controller 30 may not input the response signal S4 (Step S506) because the acceleration sensor 50 may not operate normally.

In this case, the controller 30 may determine that the acceleration function does not operate normally (Step S507) because the controller 30 may judge that the acceleration function may be out of working order due to the shocks. Accordingly, the controller 30 can operate to turn off the light source 10 (Step S508). When the acceleration sensor 50 and the communication line L1 between the acceleration sensor 50 and the controller 30 operate normally (Step S502: YES), the acceleration sensor 50 can output the response signal S4 (Step S503). When the controller 30 can input an acceleration rate in response to the response signal S4 from the acceleration sensor 50 (Step S504: YES), the controller 30 may determine that the acceleration function operates normally and also can maintain the light source 10 turning on.

However, when the controller 30 cannot input the acceleration rate from the acceleration sensor 50 in spite of the response signal S4 (Step S504: NO), the controller 30 may determine that the acceleration function does not operate normally (Step S507) because the controller 30 may judge that the acceleration function may be out of working order due to the shocks, etc. Therefore, the controller 30 can operate to turn off the light source 10 (Step S508).

According to the first embodiment of the vehicle headlight system 1 described above, the acceleration sensor 50 can be located close to the light source 10 in the ramp room 28, and thereby can detect the shocks, which cause a break, a crash and the like to the lighting unit 20, at a high accuracy substantially without a time lag. Especially, the acceleration censor 50 can be located in forward direction toward the projector lens 23 with respect to the light source 10, and therefore can immediately detect the shocks from frontward and side directions of the lighting unit 20. Accordingly, the controller 30 can immediately turn off the light source 10 with the object of protecting human eyes from a laser beam when the lighting unit 20 received the shocks.

In this case, the controller 30 can be located out of the lighting unit 20, and therefore can immediately operate the light source 10 to turn off with confidence even when the lighting unit 20 is broken by the shocks. Additionally, as described in the variation of the first embodiment of the vehicle headlight system 1, when the headlight system 1 includes the communication line L1, the headlight system 1 can enable the controller 30 to watch the acceleration rate output from the acceleration sensor 50, and therefore can immediately turn off the light source 10 with the object of protecting human eyes from the laser beam when the lighting unit 20 received the shocks.

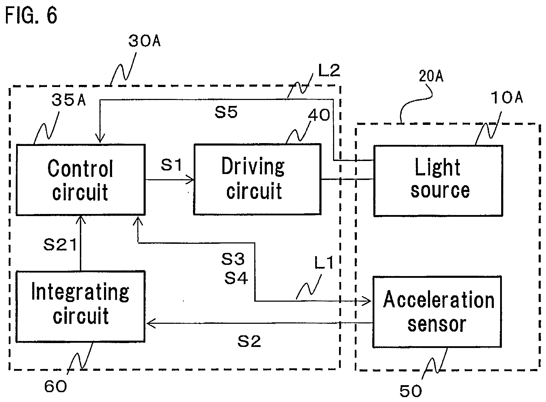

Next, a second exemplary embodiment of the vehicle headlight system will now be described with reference to FIG. 6 to FIG. 12 in addition FIG. 1 and FIG. 2. Differences between the second embodiment and the above-described first embodiment of the vehicle headlight system relates to a functional addition for watching a connecting state between a wavelength converting material and a connecting pattern and variable thresholds based on the connection state in the second embodiment, although the first embodiment includes one fixed threshold as the threshold described above.

FIG. 6 is a circuit block diagram showing a second exemplary embodiment of the vehicle headlight system shown in FIG. 3. The second embodiment of the vehicle headlight system 1 can include: a control circuit 35A of a controller 30A outputting a control signal S1 to control whether a light source 10A emits the laser beam 10LB or not, and configured to input a threshold signal S5 output from the light source 10A via a signal line L2; the driving circuit 40 receiving the control signal S1 from the control circuit 35A, and driving the light source 10A of the lighting unit 20A in accordance with the control signal S1; the acceleration sensor 50 of the lighting unit 20A outputting the acceleration signal S2: the integrating circuit 60 removing noises included in the acceleration signal S2, and output said normal acceleration signal S21 substantially not including the noises to the control circuit 35A.

When the acceleration sensor 50 includes the communication function, the control circuit 35A can output the request signal S3 to the acceleration sensor 50, and also can receive, as an input, the response signal S4 including the acceleration rate output from the acceleration sensor 50 in response of the request signal S3. In this case, when the acceleration sensor 50 and/or the communication line L1 between the acceleration sensor 50 and the control circuit 35A malfunctions, the control circuit 35A may not receive the normal response signal S4. Therefore, the second embodiment of the vehicle headlight system 1 can also enable the controller 30A to watch the acceleration rate output from the acceleration sensor 50, and therefore can immediately turn off the light source 10A with the object of protecting human eyes from a laser beam when the lighting unit 20A received the shocks in common with the first embodiment.

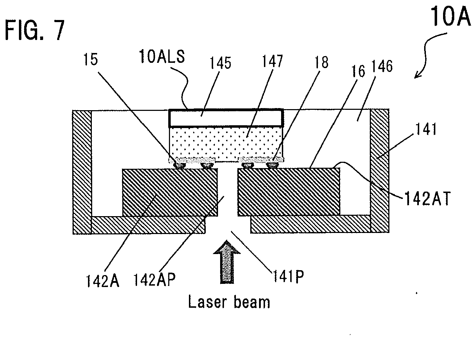

The second embodiment of the headlight system can have substantially the same structure as the first embodiment shown in FIG. 1. However, the light source 10A of the second embodiment may differ from the light source 10 included in the lighting unit 20 of the first embodiment of the headlight system 1. Accordingly, an exemplary light source used for the second embodiment of the vehicle headlight system 1 will now be described in detail with reference to FIG. 7 to FIG. 10 in addition to FIG. 2.

The lighting source 10A having a light-emitting surface 10ALS can include: the laser light-emitting device 11 emitting the laser beam; the optical lens 12 located adjacent the laser light-emitting device 11, and focusing the laser beam; the first tubular holder 13 attaching the laser light-emitting device 11 and the optical lens 12 as described above in FIG. 2; the wavelength converting material 145 configured to emit the laser beam having the desirable color tone from the light-emitting surface 10ALS by wavelength-converting the laser beam; a diffusing plate 147 disposed underneath the wavelength converting material 145; a mounting board 142A having a board opening 142AP including a circuit pattern 16 on a top surface 142AT; and a conductive layer 18 disposed underneath the diffusing plate 147, wherein the mounting board 142A carries the wavelength converting material 145, which is located on the diffusing plate 147 including the conductive layer 18, via bumps 15 that are located between the conductive layer 18 and the circuit pattern 16 of the mounting board 142A, as shown in FIG. 7, which is a schematic side cross-sectional view depicting an exemplary wavelength converting portion of the light source 10A included in the second embodiment of the vehicle headlight system.

In addition, the lighting source 10A can also include: the reflective material 146 attaching the wavelength converting material 145 disposed on the diffusing plate 147 along with the mounting board 142A, and configured to efficiently emit the laser beam from the light-emitting surface 10ALS; the second tubular holder 141 having the holder open 141P attaching the wavelength converting material 145 via the mounting board 142A, the diffusing plate 147 and the reflective material 146, and attached to the first tubular holder 13; and wherein the laser beam emitted from the leaser light-emitting device 11 is emitted toward the reflector 21 via the holder opening 141P and the board opening 142AP from the light-emitting surface 10ALS in common with a structure shown in FIG. 1 and FIG. 2.

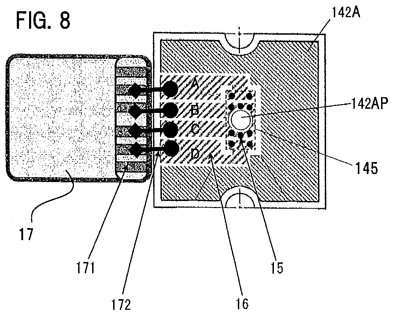

The wavelength converting portion will now be described in more detail with reference to FIG. 8, which is a schematic enlarged top view depicting the wavelength converting portion of the light source 10A included in the second embodiment. The wavelength converting portion can include: the mounting board 142A having the board opening 142A through which the laser beam passes, including a material having a high thermal conductivity such as aluminum nitride (Al N), and forming the circuit pattern 16 thereon; and a rigid terminal 171 of a flexible circuit board 17 electrically connected to the circuit pattern 16 of the mounting board 14A via a connecting wire 172, and connecting the control circuit 35A of the controller 30A via the signal line L2 as described above with reference with FIG. 6.

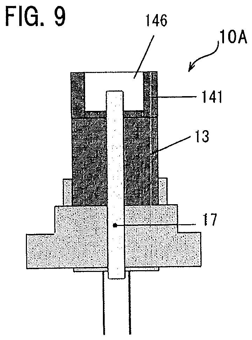

In addition, the wavelength converting portion can also include the bumps 15 electrically and mechanically connecting between the wavelength converting material 145 and mounting board 142A, and the connecting state between the wavelength converting material 145 and the mounting board 142A can be watched by the controller 30A. FIG. 9 is a schematic side view depicting the light source including the wavelength converting portion in the second embodiment of the headlight system to show an extending state of the flexible circuit board 17 from the wavelength converting portion in an outward direction of the light source 10A.

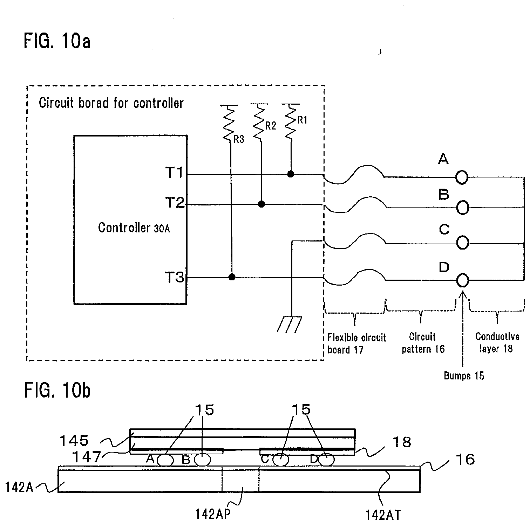

Next, exemplary methods for examining the connecting state between the wavelength converting material 145 and the mounting board 142A and for revising the threshold will now be described with reference to FIG. 10a to FIG. 11. As shown in FIG. 10b, the wavelength converting material 145 can dispose the diffusing plate 147, which is located between the wavelength converting material 145 and the conductive layer 18 so that the diffusing layer 147 can be exposed from the conductive layer 18 at a position located over the boarding opening 142AP to receive the laser beam. The mounting board 142A having the board opening 142AP can include the circuit pattern 16 on the top surface 142AT thereof, and also can attach the wavelength converting material 145, which is located on the diffusing plate 147 including the conductive layer 18, via the bumps 15 (A, B, C and D), which are located between the conductive layer 18 and the circuit pattern 16 of the mounting board 142A.

Therefore, an exemplary equivalence circuit for examining the connecting state between the wavelength converting material 145 and the mounting board 142A can be shown as FIG. 10a. In this case, the bump C can connect to ground, and each of the bumps A, B and D can connect to terminals T1, T2 and T3 via the flexible circuit board 17, respectively. Each of the bumps A, B and D can connect to pull-up resistances R1, R2 and R3, respectively, and therefore each of the terminal T1, T2 and T3 can become a high level when the connecting state broke due to a degradation of the bumps, etc. When the connecting state between the wavelength converting material 145 and the mounting board 142A is normal, each of the terminal T1, T2 and T3 can keep a low level.

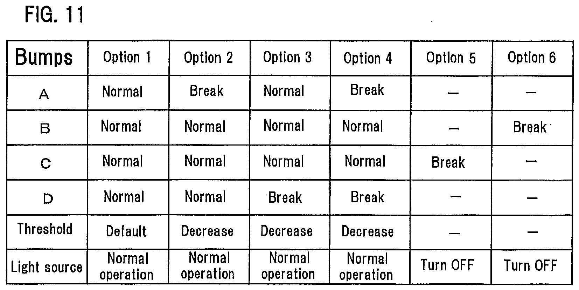

FIG. 11 is a table showing an exemplary method for revising the threshold according to the connecting state shown in FIG. 10a. Option 1 is a case where the connecting state between the wavelength converting material 145 and the mounting board 142A is normal, Options 2 and 3 is cases where the bump A or D located between the conductive layer 18 and the circuit pattern 16 of the mounting board 142A breaks. Option 4 is a case where the bumps A and D located between the conductive layer 18 and the circuit pattern 16 of the mounting board 142A break, and also each of Options 5 and 6 is a case where the bumps C and B located in an inward direction of the bumps 15 which are located between the conductive layer 18 and the circuit pattern 16 of the mounting board 142A break, respectively.

In these cases, the threshold can be set up at a default (initial value) in Option 1 because the connecting state is normal. In Options 2 and 3, the threshold can be set up at a first decreasing value, which is smaller than the initial value because the bump A or D breaks. The threshold can be set up at a second decreasing value, which is smaller than the first decreasing value because the bumps A and D break in Option 4. Additionally, in Options 5 and 6, the light source 10A can turn off in spite of the connecting state of the bumps A and/or D located in an outward direction of the bumps 15 because the laser beam may become easy to leak from the board opening 142AP of the mounting board 142A.

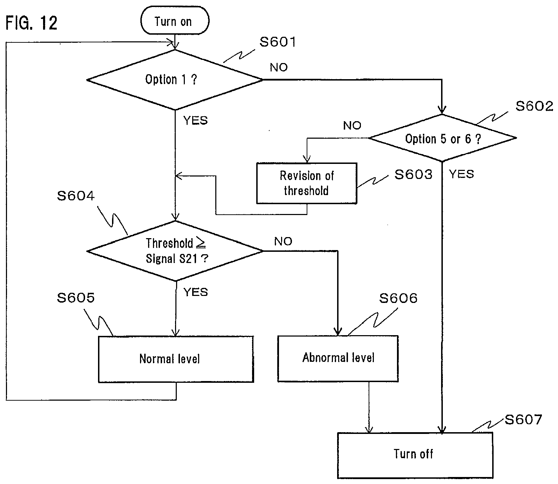

An exemplary specific method for operating Option 1 to 6 will now be described with reference to a flow chart of FIG. 12. The controller 30A can watch the above-described connecting state using the signal S5 output from the light source 10A (Step S601). When the connecting state is not normal (other than Option 1) (Step S601: NO) and when the connection state is Option 5 or 6 (Step S602: YES), the controller 30A can turn off the light source 10A (Step S607). Accordingly, the vehicle headlight system of this invention can turn off the light source 10A by anticipating a degradation of the light source 10A, which cannot be accomplished by the above-described conventional light source and the conventional headlight system.

When the connection state is neither Option 5 nor Option 6 (Step S602: No), the controller 30A can revise the threshold from the initial value to either the first decreasing value or the second decreasing value in accordance with the above-described table (Step S603). Then the controller can compare the threshold with the normal acceleration rate S21 output from the integrating circuit 60 (Step S604). When the threshold is more than the normal acceleration rate S21 (Step S604: YES), the controller 30A can determine that the normal acceleration rate S21 is within the normal level, and also can return to Step S601 while turning on the light source 10A. When the threshold is not more than the normal acceleration rate S21 (Step S604: NO), the controller 30A can determine that the normal acceleration rate S21 is an abnormal level (Step S606), and also can turn off the light source 10A (Step S607).

As described above, the controller 30A can examine the connecting state between the wavelength converting material and the mounting board, and also can control to turn off the laser light-emitting device 11 when the threshold is less than the value of the acceleration signal, which is caused by shocks. Thus, the presently invention can provide vehicle headlight systems using the lighting system, which can turn off the laser light-emitting device 11 by anticipating a degradation of the laser light source.

The lighting system of this invent can be structured by using necessary elements in accordance with usages. The lighting system can provide various color lights including white color light, which mixes the wavelength-converted light by the wavelength converting material using a part of the laser beam emitted from the laser light-emitting device 11 as an exciting light with another of the direct laser beam. Therefore, the invention can provide lighting systems including an eye-safe function, which can emit light having various color tones including a substantially white color light, and which can be used as a light source for various lighting units such as vehicle lamps, general lighting, a stage lighting, lighting for show windows, etc.

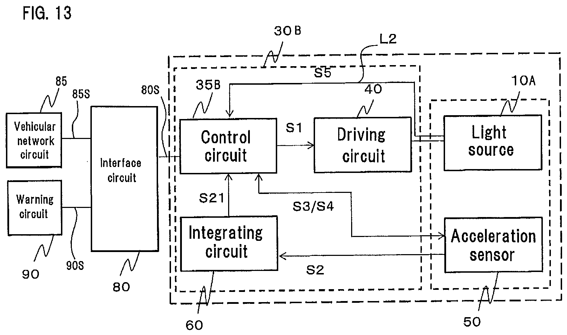

A third exemplary embodiment of the vehicle headlight system 1 will now be described with reference to FIG. 13. Differences between the third embodiment and each of the first embodiment and the second embodiment of the headlight system relate to including an interface circuit. FIG. 13 shows the third embodiment of the headlight system using the second embodiment of the headlight system 1 shown in FIG. 6. The third embodiment of the headlight system using the first embodiment of the headlight system shown in FIG. 3 can also be employed as the third embodiment, although a figure for the third embodiment using the first embodiment is abbreviated. Accordingly, the interface circuit 80 and elements associated with the interface circuit 80 will now be described.

The interface circuit 80 can receive, as an input, light source data 80S such as Option 1 to Option 6, turning-on/off data of the light source 10 (and/or 10A) and the like from a control circuit 35B. For example, when the connection state is either Option 5 or Option 6, the interface circuit 80 can output warning data 90S to a warning circuit 90. The warning circuit 90 can light a warning signal in accordance with the warning data 90S, and therefore can inform drivers of the subject vehicle about the connecting state. Additionally, when a controller 30B turns off the light source 10A due to the above-described big shocks, the interface circuit 80 can output emergency data 85S to a vehicle network circuit 85. The vehicle network circuit 85 can light a hazard lamp and the like, and therefore can inform other drivers about a break of the subject vehicle.

The lighting unit 20 shown in FIG. 1 can be used for a right lamp unit and a left lamp unit attached to each of a right front and a left front of the subject vehicle incorporating the vehicle headlight system 1, respectively. The right lamp unit of the lighting unit 20 is substantially same as the left lamp unit. Accordingly, only the lighting unit 20 is described above, and descriptions of the right and the left lamp units are abbreviated above.

According to the exemplary vehicle headlight system, the controller always watches the degradation of the connecting state between the wavelength converting material and the mounting board, and also can control to turn off the laser light-emitting device when a variable threshold is less than the value of the acceleration signal, which is caused by shocks. Thus, the presently invention can provide vehicle headlight systems using the lighting system, which can turn off the laser light-emitting device by anticipating the degradation of the laser light source.

Various modifications of the above invention can be made without departing from the scope of the present invention. For example, cases where the light unit 20 includes the reflector 21 formed in a paraboloidal shape are described above. However, the lamp unit 20 is not limited to this structure and can include the reflector 21 formed in an ellipsoidal shape and the like. While there has been described what are at present considered to be exemplary embodiments of the invention, it will be understood that various modifications may be made thereto, and it is intended that the appended claims cover such modifications as fall within the scope of the invention.

The lighting unit 20 shown in FIG. 1 can be used for a right lamp unit and a left lamp unit attached to each of a right front and a left front of the subject vehicle incorporating the vehicle headlight system 1, respectively. The right lamp unit of the lighting unit 20 is substantially same as the left lamp unit. Accordingly, only the lighting unit 20 is described above, and descriptions of the right and the left lamp units are abbreviated above.

According to the exemplary vehicle headlight system, while the controller always watch the degradation of the connecting state between the wavelength converting material and the mounting board, and also can control to turn off the laser light-emitting device when a variable threshold is less than the value of the acceleration signal, which is caused by shocks. Thus, the presently invention can provide vehicle headlight systems using the lighting system, which can turn off the laser light-emitting device by anticipating the degradation of the laser light source

Various modifications of the above invention can be made without departing from the scope of the presently invention, which is defined by the appended claims. For example, cases where the light unit 20 includes the reflector 21 formed in a paraboloidal shape are described above. However, the lamp unit 20 is not limited to this structure and can include the reflector 21 formed in an ellipsoidal shape and the like.

## Claims

1. A lighting system having a lamp room (28) and a light-emitting direction (20LD), comprising:
a light source (10) including a laser light-emitting device (11) and a wavelength converting material (145), the light source (10) being located in the lamp room (28) of the lighting system, the wavelength converting material (145) formed in a planar shape having a light-emitting surface (10LS), the wavelength converting material (145) facing the laser light-emitting device (11) in an opposite direction of the light-emitting surface (10LS) of the wavelength converting material (145), the light-emitting surface (10LS) of the wavelength converting material (145) emitting a laser beam (10LB) having a different light-emitting wavelength from a light-emitting wavelength of a laser beam emitted from the laser light-emitting device (11), after the laser beam emitted from the laser light-emitting device (11) passes though the wavelength converting material (145);
a reflector (21) located in the lamp room (28) and configured to reflect the laser beam (10LB) emitted from the light-emitting surface (10LS) of the wavelength converting material (145) in the light-emitting direction (20LD) of the lighting system;
a circuit board (51) located adjacent the reflector (21) in the lamp room (28), and located on an opposite side of the light source (10) with respect to the reflector (21);
an acceleration sensor (50) mounted on the circuit board (51), the acceleration sensor (50) being located in the light-emitting direction (20LD) of the lighting system with reference to the light source (10), the acceleration sensor (50) detecting a shock as an acceleration rate, and outputting the acceleration rate as an acceleration signal (S2);
a controller (30) receiving the acceleration signal (S2) as an input from the acceleration sensor (50), and comparing the acceleration signal (S2) with a threshold; and
an integrating circuit (60) connected between the acceleration sensor (50) and a control circuit (35) of the controller (30) to remove noises included in the acceleration signal (S2);
wherein the controller (30) is configured to turn off the laser light-emitting device (11) of the light source (10) when the threshold is less than a value of the acceleration signal (S2),
wherein the acceleration sensor (50) and the controller (30) are connected via a communication line (L1), and the acceleration sensor (50) outputs the acceleration signal (S2) in accordance with a request signal (S3) output from the controller (30), and
wherein the controller (30) is configured to turn off the laser light-emitting device (11) when the controller (30) does not receive the acceleration signal (S2) from the acceleration sensor (50) in accordance with the request signal (S3) output from the controller (30).

2. The lighting system according to claim 1, wherein:
the light source (10A) further includes a mounting board (142A) having a board opening (142AP), the wavelength converting material (145) facing the laser light-emitting device (11A) in an opposite direction of the light-emitting surface (10LS) of the wavelength converting material (145) via the board opening (142AP) of the mounting board (142A), the mounting board (142A) including a circuit pattern (16) that surrounds the board opening (142AP) of the mounting board (142A) toward the wavelength converting material (145), and the mounting board (142A) mounting the wavelength converting material (145) including a conductor pattern (18) that surrounds the laser beam emitted from the laser light-emitting device (11) in a direction toward the laser light-emitting device (11) via bumps (15) located between the circuit pattern (16) of the mounting board (142A) and the conductor pattern (18) of the wavelength converting material (145), wherein the bumps (15) are divided into a plurality of bump groups (A, B, C, D), which are isolated with respect to each other and are connected to the controller (30A) to examine a connecting state between the wavelength converting material (145) and the mounting board (142A);
wherein the controller (30A) is configured to vary the threshold in accordance with the connecting state between the wavelength converting material (145) and the mounting board (142A).

3. A vehicle headlight system including the lighting system according to any of the preceding claims, further comprising:
a casing (26) having an opening (26P);
an outer lens (27) made from a transparent material, the outer lens (27) being attached to the casing (26) and covering the opening (26P) of the casing (26), thereby forming the lamp room (28); and
a projector lens (23) located between the reflector (21) and the outer lens (27).

4. The vehicle headlight system according to claim 3, further comprising:
a reflector opening (21a) included in the reflector (21) for leaking a part of the laser beam (10LB) from the reflector (21); and
a shading plate (25) located in an opposite direction of the light source (10) with respect to the reflector (21), and shading the part of the laser beam (10LB).

5. The vehicle headlight system according to claim 3 or 4, further comprising:
an interface circuit (80) connected to the controller (30).

## Patentansprüche

1. Beleuchtungssystem mit einem Lampenraum (28) und einer Lichtemissionsrichtung (20LD), welches Folgendes aufweist:
eine Lichtquelle (10), die eine Laserlichtemissionsvorrichtung (11) und ein Wellenlängenumwandlungsmaterial (145) aufweist, wobei die Lichtquelle (10) in dem Lampenraum (28) des Beleuchtungssystems angeordnet ist, wobei das Wellenlängenumwandlungsmaterial (145) in einer ebenen Form geformt ist, die eine Lichtemissionsfläche (10LS) hat, wobei das Wellenlängenumwandlungsmaterial (145) zu der Laserlichtemissionsvorrichtung (11) in einer entgegengesetzten Richtung zur Lichtemissionsfläche (10LS) des Wellenlängenumwandlungsmaterials (145) weist, wobei die Lichtemissionsfläche (10LS) des Wellenlängenumwandlungsmaterials (145) einen Laserstrahl (10LB) mit einer anderen Lichtemissionswellenlänge als eine Lichtemissionswellenlänge eines Laserstrahls emittiert, der von der Laserlichtemissionsvorrichtung (11) emittiert wird, nachdem der Laserstrahl, der von der Laserlichtemissionsvorrichtung (11) emittiert wurde, durch das Wellenlängenumwandlungsmaterial (145) gelaufen ist;
einen Reflektor (21), der in dem Lampenraum (28) angeordnet ist und konfiguriert ist, um den Laserstrahl (10LB), der von der Lichtemissionsfläche (10LS) des Wellenlängenumwandlungsmaterials (145) emittiert wurde, in der Lichtemissionsrichtung (20LD) des Beleuchtungssystems zu reflektieren;
eine Leiterplatte (51), die benachbart zum Reflektor (21) im Lampenraum (28) angeordnet ist und auf einer gegenüberliegenden Seite der Lichtquelle (10) bezüglich des Reflektors (21) angeordnet ist;
einen Beschleunigungssensor (50), der auf der Leiterplatte (51) befestigt ist, wobei der Beschleunigungssensor (50) in der Lichtemissionsrichtung (20LD) des Beleuchtungssystems mit Bezugnahme auf die Lichtquelle (10) angeordnet ist, wobei der Beschleunigungssensor (50) einen Stoß als eine Beschleunigungsrate detektiert und die Beschleunigungsrate als ein Beschleunigungssignal (S2) ausgibt;
eine Steuervorrichtung (30), die das Beschleunigungssignal (S2) als eine Eingangsgröße von dem Beschleunigungssensor (50) aufnimmt und das Beschleunigungssignal (S2) mit einer Schwelle vergleicht; und
eine Integrierungsschaltung (60), die zwischen dem Beschleunigungssensor (50) und einer Steuerschaltung (35) der Steuervorrichtung (30) angeschlossen ist, um Rauschen zu entfernen, welches in dem Beschleunigungssignal (S2) enthalten ist;
wobei die Steuervorrichtung (30) konfiguriert ist, um die Laserlichtemissionsvorrichtung (11) der Lichtquelle (10) auszuschalten, wenn die Schwelle geringer ist als ein Wert des Beschleunigungssignals (S2),
wobei der Beschleunigungssensor (50) und die Steuervorrichtung (30) über eine Kommunikationsleitung (L1) verbunden sind, und wobei der Beschleunigungssensor (50) das Beschleunigungssignal (S2) in Übereinstimmung mit einem Anforderungssignal (S3) ausgibt, welches von der Steuervorrichtung (30) ausgegeben wird, und
wobei die Steuervorrichtung (30) konfiguriert ist, um die Laserlichtemissionsvorrichtung (11) auszuschalten, wenn die Steuervorrichtung (30) nicht das Beschleunigungssignal (S2) vom Beschleunigungssensor (50) in Übereinstimmung mit dem Anforderungssignal (S3) empfängt, das von der Steuervorrichtung (30) ausgegeben wird.

2. Beleuchtungssystem nach Anspruch 1, wobei
die Lichtquelle (10A) weiter eine Befestigungsplatte (142A) mit einer Plattenöffnung (142AP) aufweist, wobei das Wellenlängenumwandlungsmaterial (145) zu der Laserlichtemissionsvorrichtung (11A) in einer entgegengesetzten Richtung der Lichtemissionsfläche (10LS) des Wellenlängenumwandlungsmaterials (145) über die Plattenöffnung (142AP) der Befestigungsplatte (142A) weist, wobei die Befestigungsplatte (142A) ein Schaltungsmuster (16) aufweist, welches die Plattenöffnung (142AP) der Befestigungsplatte (142A) zu dem Wellenlängenumwandlungsmaterial (145) umgibt, und wobei die Befestigungsplatte (142A), die das Wellenlängenumwandlungsmaterial (145) befestigt bzw. trägt, ein Leitermuster (18) aufweist, welches den Laserstrahl, der von der Laserlichtemissionsvorrichtung (11) emittiert wird, in einer Richtung zu der Laserlichtemissionsvorrichtung (11) umgibt, und zwar über Erhöhungen (15), die zwischen dem Schaltungsmuster (16) der Befestigungsplatte (142A) und dem Leitermuster (18) des Wellenlängenumwandlungsmaterials (145) angeordnet sind, wobei die Erhöhungen (15) in eine Vielzahl von Erhöhungsgruppen (A; B; C; D) aufgeteilt sind, die mit Bezug zueinander isoliert sind und mit der Steuervorrichtung (30A) verbunden sind, um einen Verbindungszustand zwischen dem Wellenlängenumwandlungsmaterial (145) und der Befestigungsplatte (142A) zu untersuchen;
wobei die Steuervorrichtung (30A) konfiguriert ist, um die Schwelle in Übereinstimmung mit dem Verbindungszustand zwischen dem Wellenlängenumwandlungsmaterial (145) und der Befestigungsplatte (142A) zu variieren.

3. Fahrzeugscheinwerfersystem, welches das Beleuchtungssystem nach einem der vorhergehenden Ansprüche aufweist und weiter Folgendes aufweist:
ein Gehäuse (26) mit einer Öffnung (26P);
eine äußere Linse (27), die aus einem transparenten Material gemacht ist, wobei die äußere Linse (27) an dem Gehäuse (26) angebracht ist und die Öffnung (26P) des Gehäuses (26) bedeckt, wodurch der Lampenraum (28) geformt wird; und
eine Projektorlinse (23), die zwischen dem Reflektor (21) und der äußeren Linse (27) angeordnet ist.

4. Fahrzeugscheinwerfersystem nach Anspruch 3, das weiter Folgendes aufweist:
eine Reflektoröffnung (21a), die in dem Reflektor (21) vorgesehen ist, um einen Teil des Laserstrahls (10LB) aus dem Reflektor (21) herauslecken zu lassen bzw. herauszuleiten; und
eine Abschattungsplatte (25), die in einer entgegengesetzten Richtung der Lichtquelle (10) bezüglich des Reflektors (21) angeordnet ist und den Teil des Laserstrahls (10LB) abschattet.

5. Fahrzeugscheinwerfersystem nach Anspruch 3 oder 4, welches weiter Folgendes aufweist:
eine Schnittstellenschaltung (80), die mit der Steuervorrichtung (30) verbunden ist.

## Revendications

1. Système d'éclairage ayant une salle de lampe (28) et une direction d'émission de lumière (20LD), comprenant :
une source de lumière (10) comportant un dispositif émetteur de lumière laser (11) et un matériau de conversion de longueur d'onde (145), la source de lumière (10) étant située dans la salle de lampe (28) du système d'éclairage, le matériau de conversion de longueur d'onde (145) formé sous une forme plane ayant une surface émettrice de lumière (10LS), le matériau de conversion de longueur d'onde (145) faisant face au dispositif émetteur de lumière laser (11) dans une direction opposée de la surface émettrice de lumière (10LS) du matériau de conversion de longueur d'onde (145), la surface émettrice de lumière (10LS) du matériau de conversion de longueur d'onde (145) émettant un faisceau laser (10LB) ayant une longueur d'onde d'émission de lumière différente d'une longueur d'onde d'émission de lumière d'un faisceau laser émis par le dispositif émetteur de lumière laser (11), après que le faisceau laser émis par le dispositif émetteur de lumière laser (11) a traversé le matériau de conversion de longueur d'onde (145) ;
un réflecteur (21) situé dans la salle de lampe (28) et configuré pour réfléchir le faisceau laser (10LB) émis par la surface émettrice de lumière (10LB) du matériau de conversion de longueur d'onde (145) dans la direction d'émission de lumière (20LD) du système d'éclairage ;
une carte de circuit (51) située adjacente au réflecteur (21) dans la salle de lampe (28), et située sur un côté opposé de la source de lumière (10) par rapport au réflecteur (21) ;
un capteur d'accélération (50) monté sur la carte de circuit (51), le capteur d'accélération (50) étant situé dans la direction d'émission de lumière (20LD) du système d'éclairage s'agissant de la source de lumière (10), le capteur d'accélération (50) détectant un choc en tant que taux d'accélération, et fournissant le taux d'accélération sous forme d'un signal d'accélération (S2) ;
un contrôleur (30) recevant le signal d'accélération (S2) sous forme d'une entrée provenant du capteur d'accélération (50) et comparant le signal d'accélération (S2) à un seuil ; et
un circuit d'intégration (60) connecté entre le capteur d'accélération (50) et un circuit de commande (35) du contrôleur (30) pour retirer des bruits inclus dans le signal d'accélération (S2) ;
dans lequel le contrôleur (30) est configuré pour désactiver le dispositif émetteur de lumière laser (11) de la source de lumière (10) lorsque le seuil est inférieur à une valeur du signal d'accélération (S2),
dans lequel le capteur d'accélération (50) et le contrôleur (30) sont connectés par l'intermédiaire d'une ligne de communication (L1), et le capteur d'accélération (50) fournit le signal d'accélération (S2) conformément à un signal de requête (S3) fourni par le contrôleur (30), et
dans lequel le contrôleur (30) est configuré pour désactiver le dispositif émetteur de lumière laser (11) lorsque le contrôleur (30) ne reçoit pas le signal d'accélération (S2) en provenance du capteur d'accélération (50) conformément au signal de requête (S3) fourni par le contrôleur (30).

2. Système d'éclairage selon la revendication 1, dans lequel :
la source de lumière (10A) comporte en outre une carte de montage (142A) ayant une ouverture de carte (142AP), le matériau de conversion de longueur d'onde (145) faisant face au dispositif émetteur de lumière laser (11A) dans une direction opposée de la surface émettrice de lumière (10LS) du matériau de conversion de longueur d'onde (145) à travers l'ouverture de carte (142AP) de la carte de montage (142A), la carte de montage (142A) comportant un motif de circuit (16) qui entoure l'ouverture de carte (142AP) de la carte de montage (142A) vers le matériau de conversion de longueur d'onde (145), et la carte de montage (142A) supportant le matériau de conversion de longueur d'onde (145) comportant un motif conducteur (18) qui entoure le faisceau laser émis par le dispositif émetteur de lumière laser (11) dans une direction vers le dispositif émetteur de lumière laser (11) par l'intermédiaire de bossages (15) situés entre le motif de circuit (16) de la carte de montage (142A) et le motif conducteur (18) du matériau de conversion de longueur d'onde (145), dans lequel les bossages (15) sont répartis en une pluralité de groupes de bossages (A, B, C, D), qui sont isolés les uns des autres et sont connectés au contrôleur (30A) pour examiner un état de connexion entre le matériau de conversion de longueur d'onde (145) et la carte de montage (142A) ;
dans lequel le contrôleur (30A) est configuré pour faire varier le seuil conformément à l'état de connexion entre le matériau de conversion de longueur d'onde (145) et la carte de montage (142A).

3. Système de phare de véhicule comprenant le système d'éclairage selon l'une quelconque des revendications précédentes, comprenant en outre :
un boîtier (26) ayant une ouverture (26P) ;
une lentille extérieure (27) constitué d'un matériau transparent, la lentille extérieure (27) étant fixée au boîtier (26) et recouvrant l'ouverture (26P) du boîtier (26), formant ainsi la chambre de lampe (28) ; et
une lentille de projecteur (23) située entre le réflecteur (21) et la lentille extérieure (27).

4. Système de phare de véhicule selon la revendication 3, comprenant en outre :
une ouverture de réflecteur (21a) incluse dans le réflecteur (21), et faisant fuir une partie du faisceau laser (10LB) provenant du réflecteur (21) ; et
une plaque d'ombrage (25) située dans une direction opposée à la source lumineuse (10) par rapport au réflecteur (21), et ombrageant la partie du faisceau laser (10LB).

5. Système de phare de véhicule selon la revendication 3 ou 4, comprenant en outre :
un circuit d'interface (80) connecté au contrôleur (30).
